# EUROPEAN PATENT APPLICATION

(11) **EP 4 521 878 A1**
(43) Date of publication of application: **12.03.2025**
(21) Application number: 24798710.0
(22) Date of filing: 08.04.2024
(51) Int. Cl.: H10B 43/27, H01L 21/20, H01L 21/28, H10D 30/01, H10D 30/67, H10D 30/68, H10D 30/69, H10B 41/27

(54) **SEMICONDUCTOR ELEMENT MANUFACTURING METHOD AND SEMICONDUCTOR ELEMENT**

(30) Priority: 14.07.2023 JP 2023115732
(71) Applicant: Canon Anelva Corporation, Kawasaki-shi, Kanagawa 215-8550 (JP)
(72) Inventor: MATSUKI, Naoko, Kawasaki-shi, Kanagawa 2158550 (JP); YOSHIDA, Yuto, Kawasaki-shi, Kanagawa 2158550 (JP); IRISAWA, Toshikazu, Kawasaki-shi, Kanagawa 2158550 (JP)
(74) Representative: TBK
(86) International application number: PCT/JP2024/014280
(87) International publication number: WO 2025/017981

(57) **Abstract**

A method of manufacturing a semiconductor device, includes a conversion step of converting amorphous silicon into single-crystal silicon. the conversion step includes a first step of forming a silicide to contact the amorphous silicon by forming, by treatment with heating, a first film containing a first material to cover the amorphous silicon, a second step of forming a compound formed by Si, the first material, and a second material to contact the silicide by forming, by treatment with heating, a second film containing the second material to cover the silicide after the first step, and a third step of changing the silicide remaining after the second step to the compound by annealing, the first material is one material selected from a group consisting of Ni, Pd, Ti, Cu, Pt, Co, Mo, Mg, W, Cr, and Mn, and the second material is one material selected from a group consisting of Al, Au, Sb, In, Ag, and Ga.

## Description

### TECHNICAL FIELD

The present invention relates to a method of manufacturing a semiconductor device, and a semiconductor device.

### BACKGROUND ART

As one of methods of solving performance degradation caused by an increase in channel resistance or the like with respect to a semiconductor device (for example, a thin-film transistor or a semiconductor storage device), there is provided a method of single-crystallizing amorphous silicon or polysilicon in a channel. As a single crystallization method, there is a MILC (Metal Induced Lateral Crystallization) process in which Ni silicide is used for the growth end of crystallization. As an example of the MILC process, "Thin-Film Transistor Using Metal Induced Lateral Crystallization Method and Method of Manufacturing the Same" described in PTL 1 will be explained with reference to Figs. 1 to 3. Referring to Figs. 1 to 3, reference numeral 200 denotes an insulating substrate; 210, a buffer layer; 220, an active layer; 221 and 225, source/drain regions; 223, a channel region; 230, a gate insulating film; 240, a gate electrode; 250, an interlayer insulating film, 251 and 255, contact holes; and 260, a crystallization induced metal film.

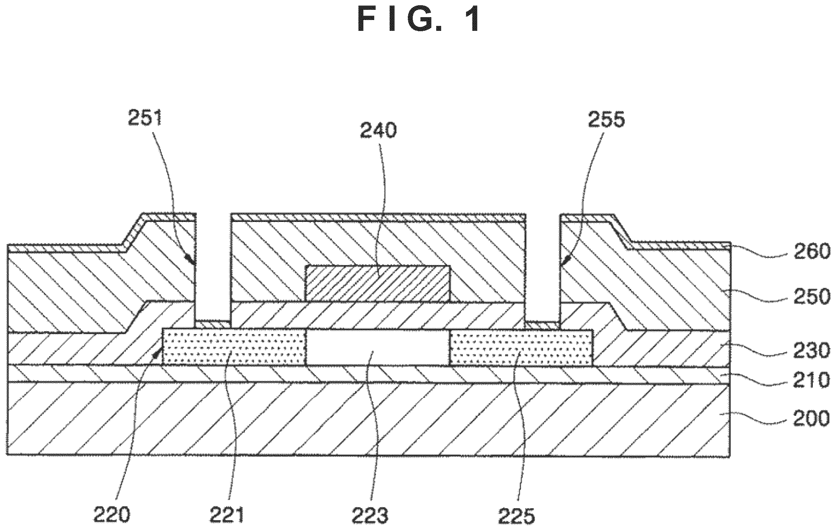

As shown in Fig. 1, the interlayer insulating film 250 is deposited on the insulating substrate 200 including the gate electrode 240 to form the contact holes 251 and 255 that expose parts of the source/drain regions 221 and 225. Next, the crystallization induced metal film 260 made of Ni or the like is deposited on the insulating substrate 200 by a method such as sputtering.

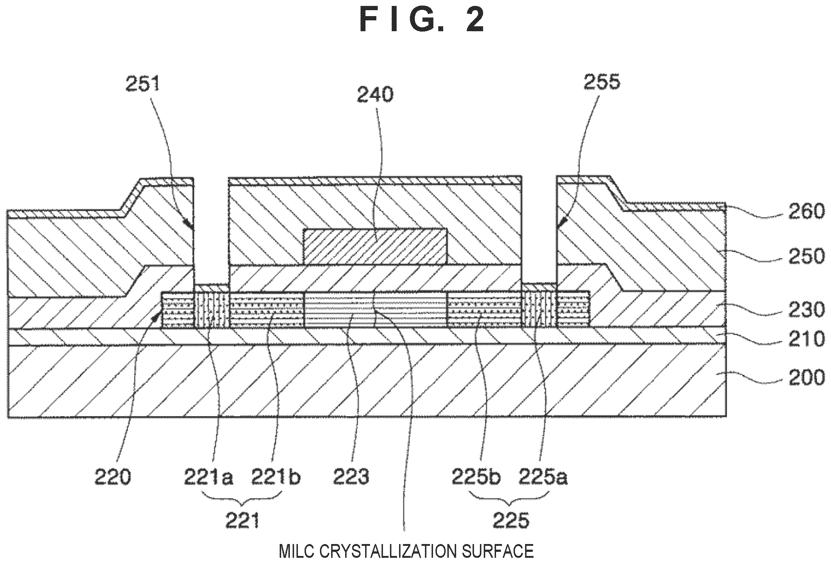

Next, as shown in Fig. 2, an amorphous silicon film of the active layer 220 is crystallized by performing annealing in a furnace, and is changed to a polysilicon film (crystallized at 550°C at a speed of 3 µm/hr). At this time, amorphous silicon in lower regions 221a and 225a below the crystallization induced metal film 260 in the contact holes 251 and 255 is crystallized by a Metal Induced Crystallization (MIC) method, and amorphous silicon in remaining regions 221b and 225b is crystallized by the MILC method.

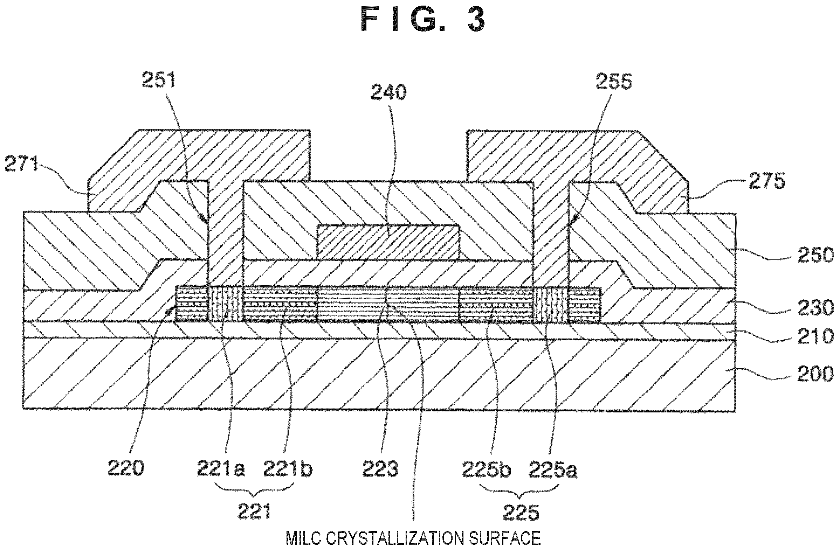

Next, as shown in Fig. 3, the crystallization induced metal film 260 is removed and source/drain electrodes 271 and 275 are formed, thereby obtaining a thin-film transistor.

PTL 2 discloses a nonvolatile semiconductor storage device that includes a semiconductor substrate, a first layer, a second conductive layer, a memory film, and a semiconductor layer, and includes a metal layer contacting the semiconductor layer and containing Ni, Co, Al, or Pd, in order to make an attempt to relax operation control and circuit layout design while improving an operation speed such as a read speed, a write speed, and a removal speed. In addition, PTL 2 discloses as follows. "In a case where the a metal layer 70 is made of a material not forming a silicide, such as Al, after annealing, a portion near a lower end portion of a semiconductor pillar SP may contain an Al alloy and a portion near an upper end portion of the semiconductor pillar SP may contain an Al alloy. Without limitation to the portions near the upper end portion and the lower end portion of the semiconductor pillar SP, the semiconductor pillar SP may contain an Al alloy."

PTL 3 discloses a semiconductor storage device including a first wiring layer, a second wiring layer, and a memory pillar in order to improve processing capability. Furthermore, according to PTL 3, since the lattice parameter of NiSi₂ has a mismatch of only about 0.3% with respect to the lattice parameter of Si, NiSi₂ is suitable for forming single-crystal silicon by the MILC method. It is disclosed that examples of a metal material for crystallizing a semiconductor pillar (for example, silicon, silicon germanium, or germanium) by the MILC method are Ni, Co, Al and Pd.

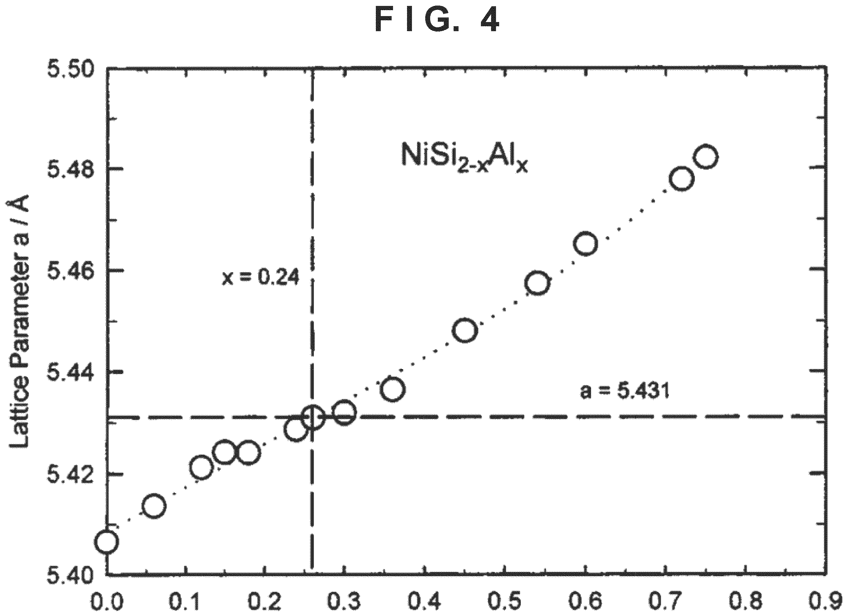

NPL 1 relates to the lattice parameter of Si, that of NiSi₂, and that of NiSi_{2-X}Al_{X}. The abscissa of Fig. 4 represents a ratio X of Al to NiSi_{2-X}Al_{X}, a represents the lattice parameter of Si, and the ordinate of Fig. 4 represents the lattice parameter. It is apparent from Fig. 4 that when the lattice parameter of NiSi₂ is 5.406, the lattice parameter of Si is 5.431, and when the ratio X of Al is 0.24, NiSi_{2-X}Al_{X} = 5.431 which matches the lattice parameter of Si. Note that the unit of the lattice parameter in NPL 1 is angstrom, and this specification also assumes that the unit of the lattice parameter is angstrom.

### CITATION LIST

### PATENT LITERATURE

PTL 1: Japanese Patent Laid-Open No. 2005-159307
PTL 2: Japanese Patent Laid-Open No. 2014-175348
PTL 3: Japanese Patent Laid-Open No. 2019-165178

### NON PATENT LITERATURE

NPL 1: Klaus et al. "Appl. Phys. Lett. 83, 497(2003)" pp. 497 - 499

### SUMMARY OF INVENTION

### TECHNICAL PROBLEM

The present invention provides a technique of converting amorphous silicon into single-crystal silicon by a silicide having a lattice parameter closer to the lattice parameter of the single-crystal silicon.

### SOLUTION TO PROBLEM

A first aspect of the present invention is related to a method of manufacturing a semiconductor device, including a conversion step of converting amorphous silicon into single-crystal silicon, and in the method of manufacturing, the conversion step includes: a first step of forming a silicide to contact the amorphous silicon by forming, by treatment with heating, a first film containing a first material to cover the amorphous silicon, a second step of forming a compound formed by Si, the first material, and a second material to contact the silicide by forming, by treatment with heating, a second film containing the second material to cover the silicide after the first step, and a third step of changing the silicide remaining after the second step to the compound by annealing, the first material is one material selected from a group consisting of Ni, Pd, Ti, Cu, Pt, Co, Mo, Mg, W, Cr, and Mn, and the second material is one material selected from a group consisting of Al, Au, Sb, In, Ag, and Ga.

A second aspect of the present invention is related to a method of manufacturing a semiconductor device, including a conversion step of converting amorphous silicon into single-crystal silicon, and in the method of manufacturing,
the conversion step includes: a first step of forming a first film containing a first material to cover the amorphous silicon, a second step of forming a second film containing a second material to cover the first film after the first step, and a third step of forming a compound containing Si, the first material, and the second material by annealing after the second step, the first material is one material selected from a group consisting of Ni, Pd, Ti, Cu, Pt, Co, Mo, Mg, W, Cr, and Mn, and the second material is one material selected from a group consisting of Al, Au, Sb, In, Ag, and Ga.

A third aspect of the present invention is related to a semiconductor device including a stacked structure of amorphous silicon, a compound, and single-crystal silicon, and in the semiconductor device, the compound is a compound of Si, a first material, and a second material, the first material is one material selected from a group consisting of Ni, Pd, Ti, Cu, Pt, Co, Mo, Mg, W, Cr, and Mn, and the second material is one material selected from a group consisting of Al, Au, Sb, In, Ag, and Ga.

### BRIEF DESCRIPTION OF DRAWINGS

Fig. 1 is a process cross-sectional view for explaining a method of manufacturing a thin-film transistor described in PTL 1;
Fig. 2 is a process cross-sectional view for explaining the method of manufacturing the thin-film transistor described in PTL 1;
Fig. 3 is a process cross-sectional view for explaining the method of manufacturing the thin-film transistor described in PTL 1;
Fig. 4 is a graph showing the relationship among the lattice parameter of Si, that of NiSi₂, and that of NiSi_{2-X}Al_{X} described in NPL 1;
Fig. 5A is a process diagram showing a method of manufacturing a semiconductor device according to the first embodiment;
Fig. 5B is a process diagram showing the method of manufacturing the semiconductor device according to the first embodiment;
Fig. 5C is a process diagram showing the method of manufacturing the semiconductor device according to the first embodiment;
Fig. 6A is a process diagram showing a method of manufacturing a semiconductor device according to the second embodiment;
Fig. 6B is a process diagram showing the method of manufacturing the semiconductor device according to the second embodiment;
Fig. 6C is a process diagram showing the method of manufacturing the semiconductor device according to the second embodiment;
Fig. 7A is a process diagram showing a method of manufacturing a semiconductor device according to the third embodiment;
Fig. 7B is a process diagram showing the method of manufacturing the semiconductor device according to the third embodiment;
Fig. 7C is a process diagram showing the method of manufacturing the semiconductor device according to the third embodiment;
Fig. 8A is a process diagram showing the method of manufacturing the semiconductor device according to the first embodiment;
Fig. 8B is a process diagram showing the method of manufacturing the semiconductor device according to the first embodiment;
Fig. 8C is a process diagram showing the method of manufacturing the semiconductor device according to the first embodiment;
Fig. 9 is a process diagram showing a method of manufacturing a semiconductor device according to the fourth embodiment;
Fig. 10 is a process diagram showing the method of manufacturing the semiconductor device according to the fourth embodiment;
Fig. 11 is a process diagram showing the method of manufacturing the semiconductor device according to the fourth embodiment;
Fig. 12 is a process diagram showing the method of manufacturing the semiconductor device according to the fourth embodiment;
Fig. 13 is a process diagram showing the method of manufacturing the semiconductor device according to the fourth embodiment;
Fig. 14 is a process diagram showing the method of manufacturing the semiconductor device according to the fourth embodiment;
Fig. 15 is a process diagram showing the method of manufacturing the semiconductor device according to the fourth embodiment;
Fig. 16 is a process diagram showing the method of manufacturing the semiconductor device according to the fourth embodiment;
Fig. 17 is a process diagram showing the method of manufacturing the semiconductor device according to the fourth embodiment;
Fig. 18A is a process diagram showing a method of manufacturing a semiconductor device according to the fifth embodiment; and
Fig. 18B is a process diagram showing the method of manufacturing the semiconductor device according to the fifth embodiment.

### DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

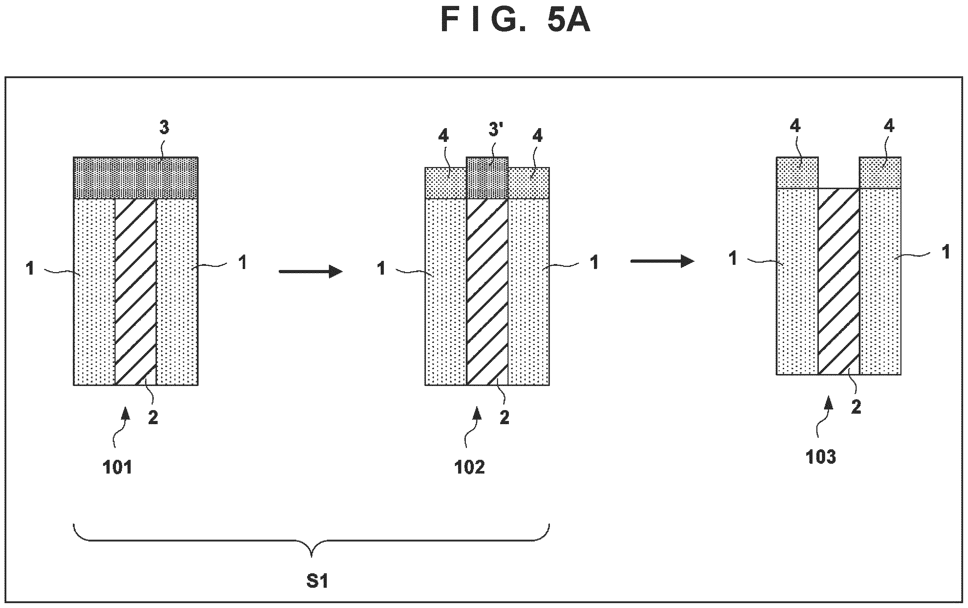

Figs. 5A to 5C are views schematically showing the first embodiment of a method of manufacturing a semiconductor device, which includes a conversion step of converting amorphous silicon 1 into single-crystal silicon 10. From the result of an experiment of heating a structure obtained by sequentially depositing an Al film and Ni film on amorphous silicon, the present inventor has found that the Al film inhibits silicidation of the Ni film. Furthermore, from the result of an experiment of heating a structure obtained by depositing an NiAl film on amorphous silicon, the present inventor has found that Al is pushed out to the surface side of the NiAl film without being contained in Ni silicide. The present inventor has found a phenomenon that when an Ni silicide film contacting amorphous silicon is formed by forming an Ni film on the amorphous silicon by treatment with heating and then an Al film is formed on the Ni silicide film by treatment with heating, Al diffuses in the Ni silicide film to form NiAlSi. Since NiAlSi has a lattice parameter close to that of single-crystal silicon, it is possible to readily obtain single-crystal silicon by performing annealing while NiAlSi is in contact with amorphous silicon. The following embodiments are based on the above knowledge.

The method of manufacturing the semiconductor device according to the first embodiment can include the conversion step of converting the amorphous silicon 1 into the single-crystal silicon 10. The amorphous silicon 1 can form part of a substrate. The conversion step can include
a first step S1 of forming Ni silicide as a silicide 4 contacting the amorphous silicon 1 by forming, by annealing with heating, a first film 3 containing Ni (nickel) as a first material to cover the amorphous silicon 1,
a second step S2 of forming NiAlSi as a compound 7 containing Si (silicon), Ni (first material), and Al (second material) to contact the silicide 4 by forming, by treatment with heating, a second film 6 containing Al (aluminum) as the second material to cover the silicide 4 after the first step S1, and
a third step S3 of changing the silicide 4 remaining after the second step S2 to an NiAlSi film as a compound 9 containing Si, Ni (first material), and Al (second material) by annealing.

This can create a structure in which NiAlSi as the compound 9 is arranged to contact the amorphous silicon 1.

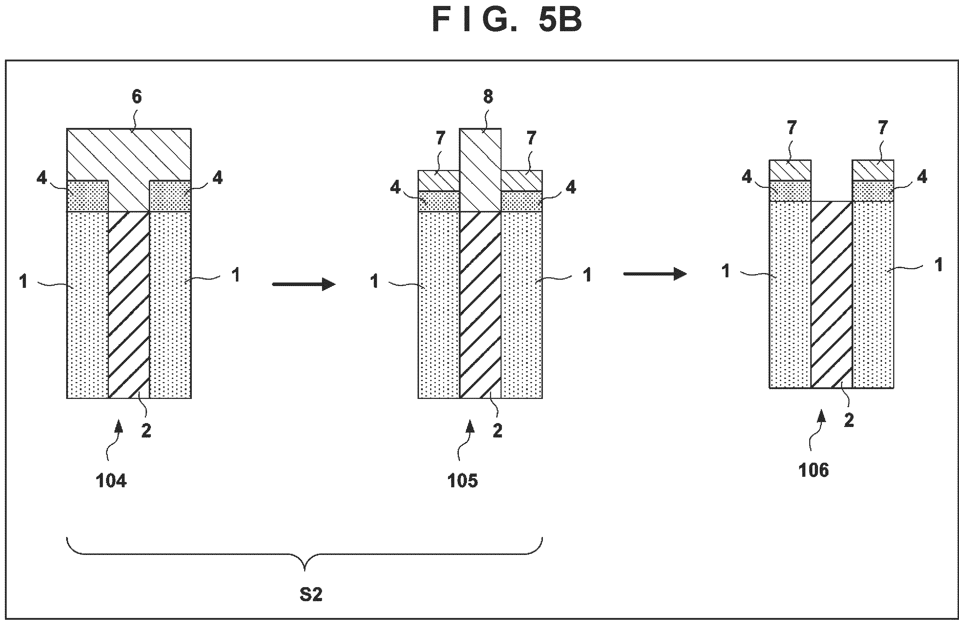

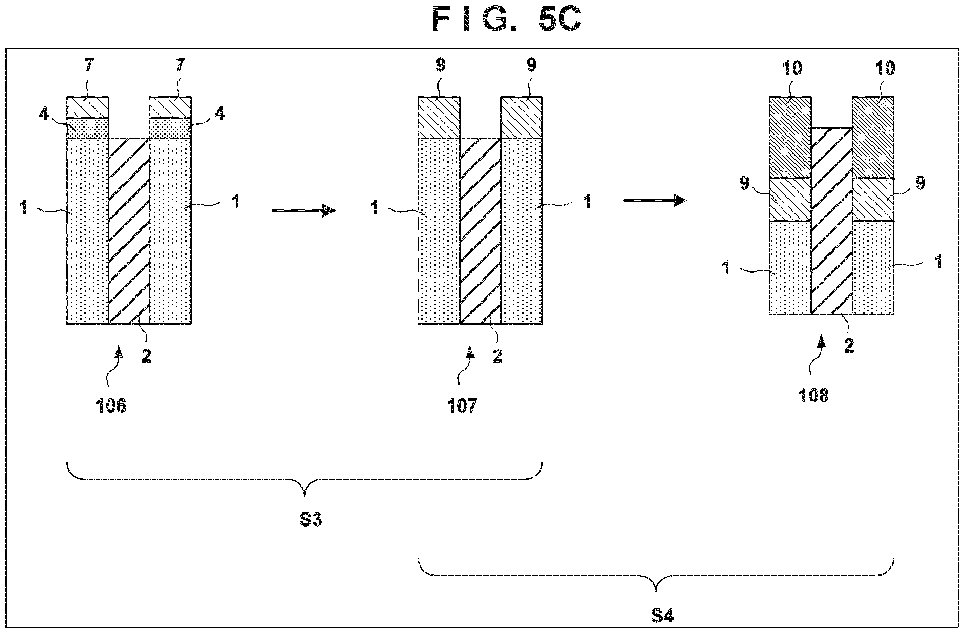

Fig. 5A shows a structure 101 in a state in which the first film 3 containing Ni as the first material is formed by annealing with heating to cover the amorphous silicon 1 in the first step S1, and a structure 102 in which Ni silicide as the silicide 4 is formed. Fig. 5B shows a structure 104 in a state in which the second film 6 containing Al as the second material is formed by treatment with heating to cover the silicide 4, and a structure 105 in a state in which NiAlSi as the compound 7 containing Si, Ni (first material), and Al (second material) is formed to contact the silicide 4. Fig. 5C shows a structure 106 containing the silicide 4 remaining after the second step S2, and a structure 107 after the silicide 4 changes to the compound 9 by annealing.

As the first material, instead of Ni, Pd (palladium), Ti (titanium), Cu (copper), Pt (platinum), Co (cobalt), Mo (molybdenum), Mg (magnesium), W (tungsten), Cr (chromium), or Mn (manganese) may be used. That is, the first material can be one material selected from a group consisting of Ni, Pd, Ti, Cu, Pt, Co, Mo, Mg, W, Cr, and Mn.

As the second material, instead of Al, Au (gold), Sb (antimony), In (indium), Ag (silver), or Ga (gallium) may be used. That is, the second material can be one material selected from a group consisting of Al, Au, Sb, In, Ag, and Ga.

A compound containing Si, the first material, and the second material is preferably, for example, NiAuSi, NiSbSi, NiInSi, NiAgSi, or NiGaSi, instead of NiAlSi.

The conversion step of converting the amorphous silicon 1 into the single-crystal silicon 10 can further include a fourth step S4 of changing at least part of the amorphous silicon 1 remaining after the third step S3 to the single-crystal silicon 10 by annealing. Fig. 5C shows a structure 108 after at least part of the amorphous silicon 1 remaining after the third step S3 changes to the single-crystal silicon 10 by annealing. The fourth step can include a MILC (Metal Induced Lateral Crystallization) process.

The substrate subject to the first step can include an insulating film 2 (for example, SiO₂: silicon dioxide) in addition to the amorphous silicon 1. The amorphous silicon 1 and the insulating film 2 can be arranged to contact each other or close to each other. In the first step S1, in addition to the silicide 4 contacting the amorphous silicon 1, a first material film 3' may be formed to contact the insulating film 2 by forming, by treatment with heating, the first film 3 containing the first material (for example, Ni) to cover the insulating film 2 in addition to the amorphous silicon 1. Fig. 5A shows the structure 102 including the first material film 3'.

In this case, the conversion step can further include, between the first step S1 and the second step S2, a step of removing the first material film 3' contacting the insulating film 2 by chemical etching or the like. Fig. 5A shows the structure 103 in which the first material film 3' is removed. By removing the first material film 3', it is possible to prevent a situation in which the silicide 4 laterally grows to be associated with another silicide 4 and thus electrical short-circuit occurs. In a case where the first material film 3' contacting the insulating film 2 is removed, in the second step S2, a second material film 8 as part of the second film 6 remains in a portion covering the insulating film 2 when forming NiAlSi as the compound 7 containing Si, Ni (first material), and Al (second material) to contact the silicide 4. The second material film 8 can be removed after the second step S2 (for example, between the second step S2 and the third step S3).

A thickness T₂ of the second film 6 formed in the second step S2 (a thickness of the second film 6 in a portion covering the Ni silicide 4) is preferably larger than a thickness T₁ of the first film 3 formed in the first step S1, and smaller than four times the thickness T₁ of the first film 3 formed in the first step S1. That is, 0 < T₂ < 4T₁ is preferably satisfied.

T₂ = 0 indicates that the value of X on the abscissa of Fig. 4 is 0. In this case, the lattice parameter of NiSi₂₋₀Al₀ (that is, NiSi₂) is 5.406. T₂ = 4T₁ indicates that the value of X on the abscissa of Fig. 4 is 0.54. When the value of X is 0.54, the lattice parameter of NiSi_{1.46}Al_{0.54} is 5.454.

If 0 < T₂ < 4T₁ is satisfied, the lattice parameter of NiSi_{2-X}Al_{X} is given by the following expression.

5.406 < lattice parameter of NiSi_{2-X}Al_{X} < 5.454

Therefore, since the lattice parameter of NiSi_{2-X}Al_{X} is close to the lattice parameter of Si = 5.430, as compared with the lattice parameter (5.406) of NiSi₂, it is known that this is suitable for forming single-crystal silicon by the MILC process.

This can reduce channel resistance that is a problem for a semiconductor device such as a thin-film transistor or a semiconductor storage device (for example, a 3D NAND memory).

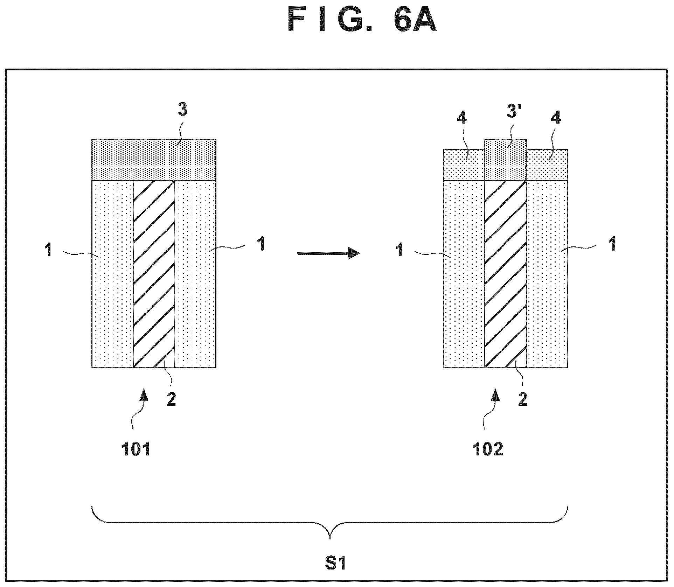

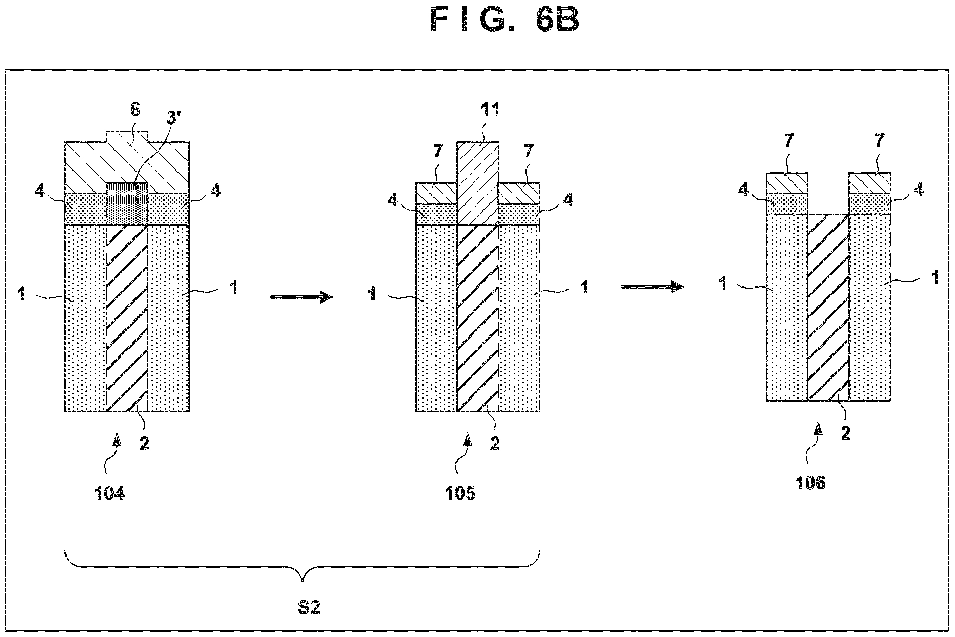

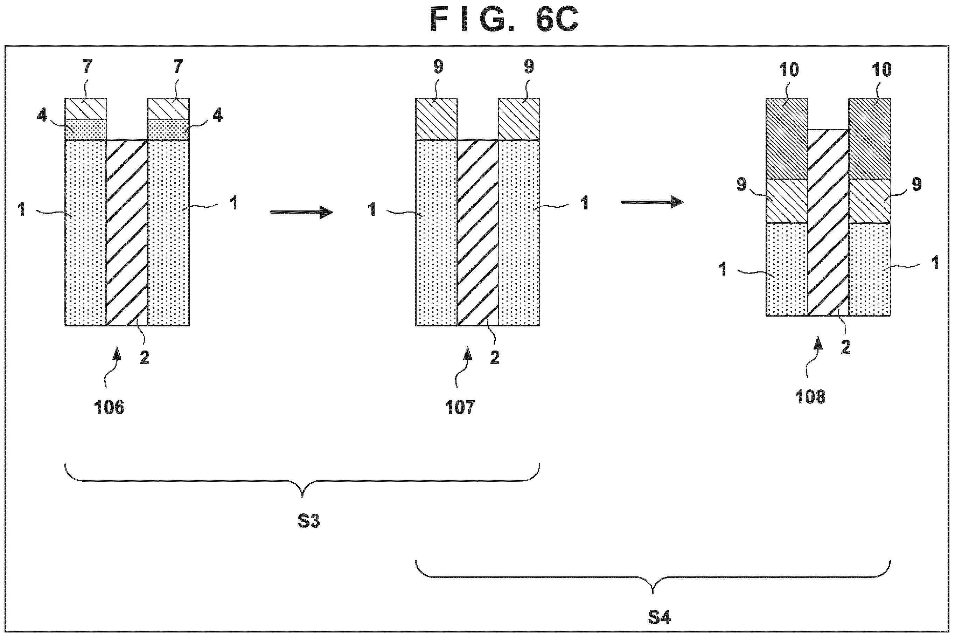

Figs. 6A to 6C are views schematically showing the second embodiment of a method of manufacturing a semiconductor device, which includes a conversion step of converting amorphous silicon 1 into single-crystal silicon 10. Matters not mentioned as the second embodiment can comply with the first embodiment. Fig. 6A schematically shows a first step S1, Fig. 6B schematically shows a second step S2, and Fig. 6C schematically shows a third step S3 and a fourth step S4.

In the second embodiment, a first material film 3' contacting an insulating film 2 is not removed between the first step S1 and the second step S2. Therefore, in the second step S2, by forming, by treatment with heating, a second film 6 containing Al as a second material to cover a silicide 4 and the first material film 3', a second compound 11 of a first material and the second material is obtained to contact the insulating film 2 in addition to a compound 7 contacting the silicide 4.

In the second embodiment, the conversion step can include, between the second step S2 and the third step S3, a step of removing the second compound 11 contacting the insulating film 2. By removing the second compound 11, it is possible to prevent a situation in which the silicide 4 laterally grows to be associated with another silicide 4 and thus electrical short-circuit occurs. Fig. 6B shows a structure 106 in which the second compound 11 is removed.

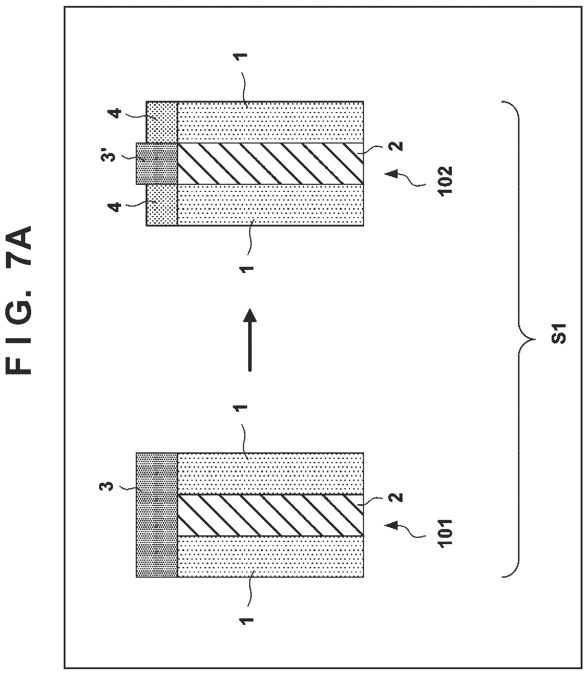

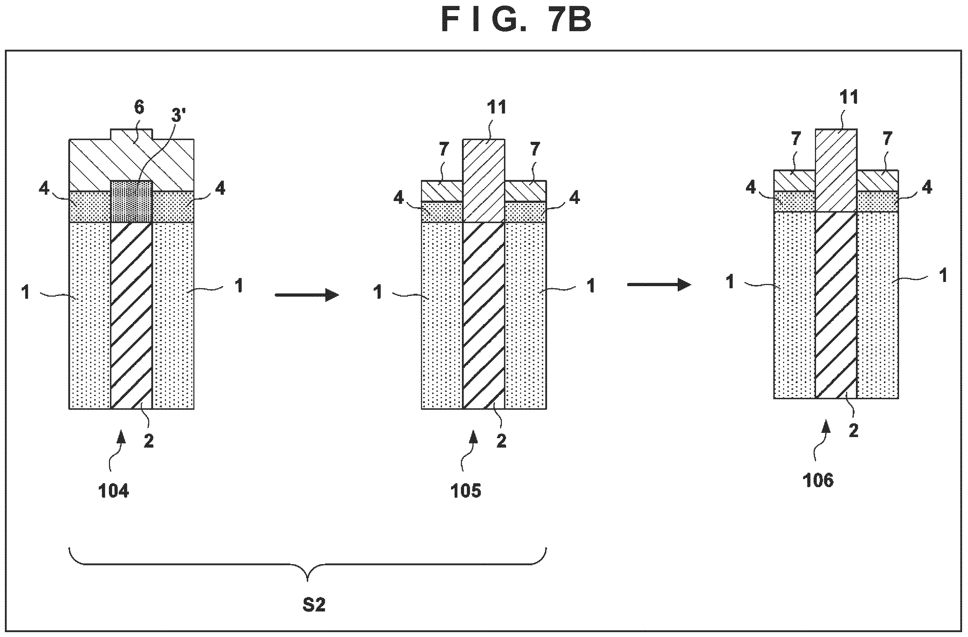

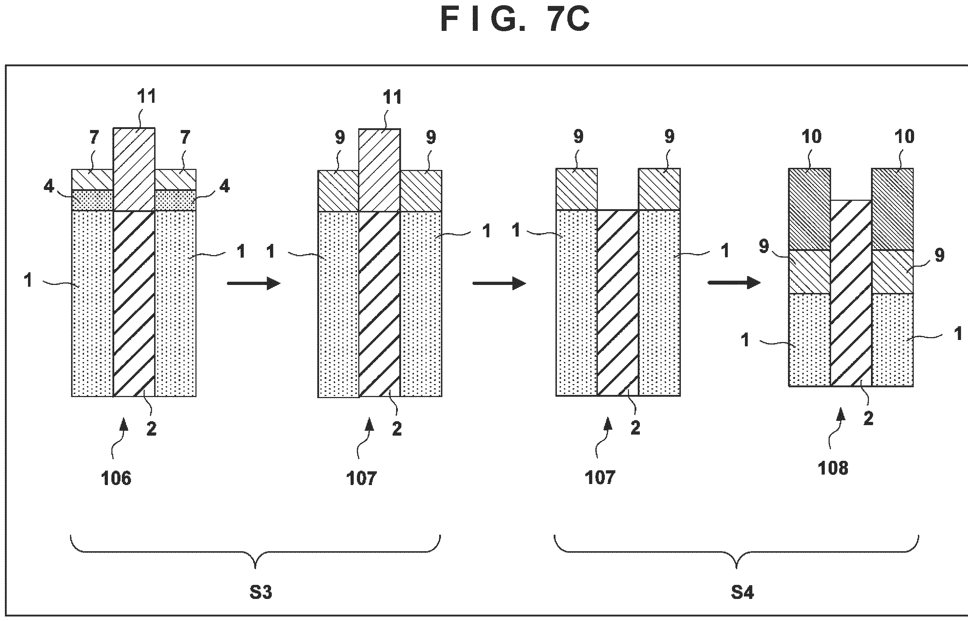

Figs. 7A to 7C are views schematically showing the third embodiment of a method of manufacturing a semiconductor device, which includes a conversion step of converting amorphous silicon into single-crystal silicon. Matters not mentioned as the third embodiment can comply with the first embodiment. Fig. 7A schematically shows a first step S1, Fig. 7B schematically shows a second step S2, and Fig. 7C schematically shows a third step S3 and a fourth step S4.

In the third embodiment, a first material film 3' contacting an insulating film 2 is not removed between the first step S1 and the second step S2. Therefore, in the second step S2, by forming, by treatment with heating, a second film 6 containing Al as a second material to cover a silicide 4 and the first material film 3', a second compound 11 of a first material and the second material is obtained to contact the insulating film 2 in addition to a compound 7 contacting the silicide 4. In the second embodiment, the second compound 11 contacting the insulating film 2 is not removed between the second step S2 and the third step S3.

In the third embodiment, the conversion step can include, after the third step S3 and more specifically between the third step S3 and the fourth step S4, a step of removing the second compound 11 contacting the insulating film 2. By removing the second compound 11, it is possible to prevent a situation in which the silicide 4 laterally grows to be associated with another silicide 4 and thus electrical short-circuit occurs. Fig. 7C shows a structure 107 in which the second compound 11 is removed.

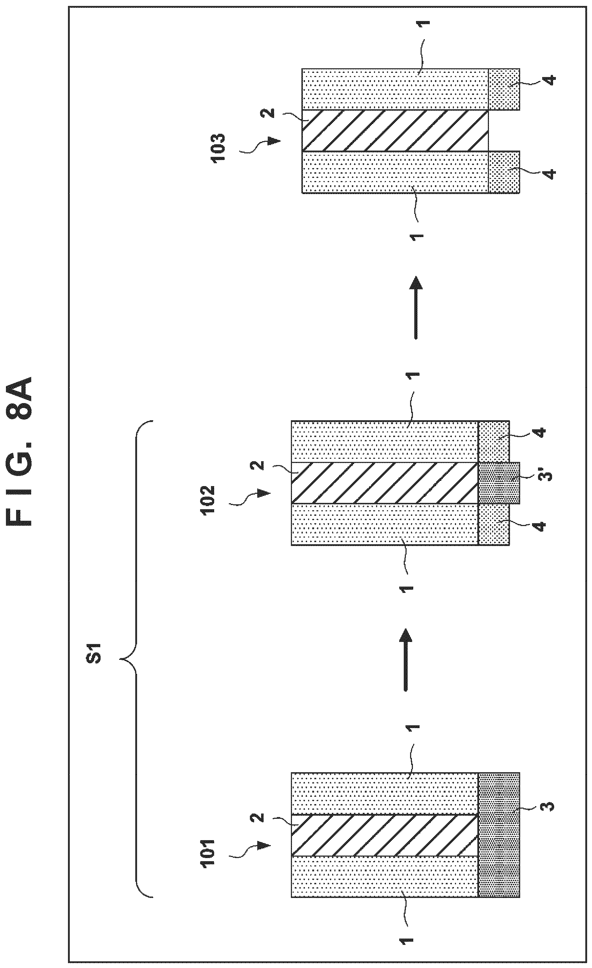

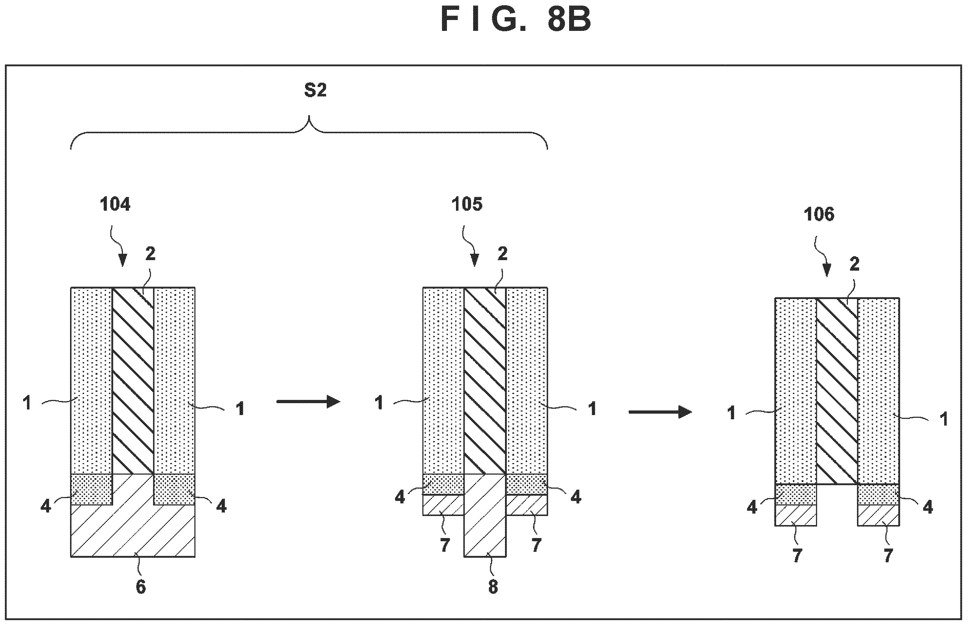

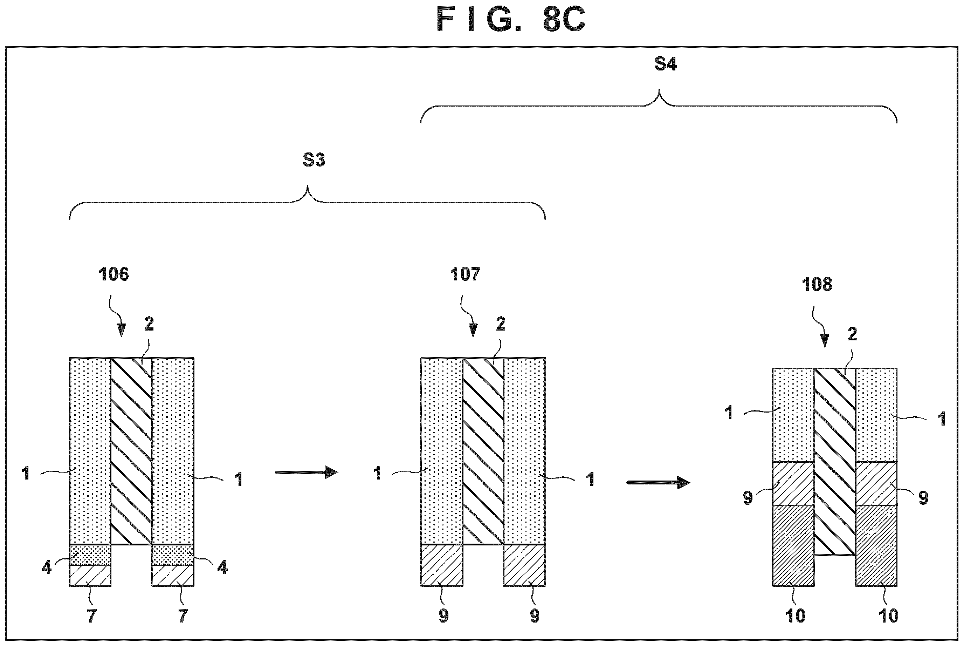

In each of the first to third embodiments, the referred drawings show that the first film and the second film are formed on the amorphous silicon 1. These drawings merely show that the first film and the second film are formed on the amorphous silicon 1 in the posture shown in the drawings. The formation of the first film and the second film on the amorphous silicon 1 does not limit the present invention to formation of the first film and the second film above the amorphous silicon 1 in a film forming apparatus. The formation of the first film and the second film on the amorphous silicon 1 includes formation of the first film and the second film below the amorphous silicon 1 in a film forming apparatus, as exemplified in Figs. 8A to 8C.

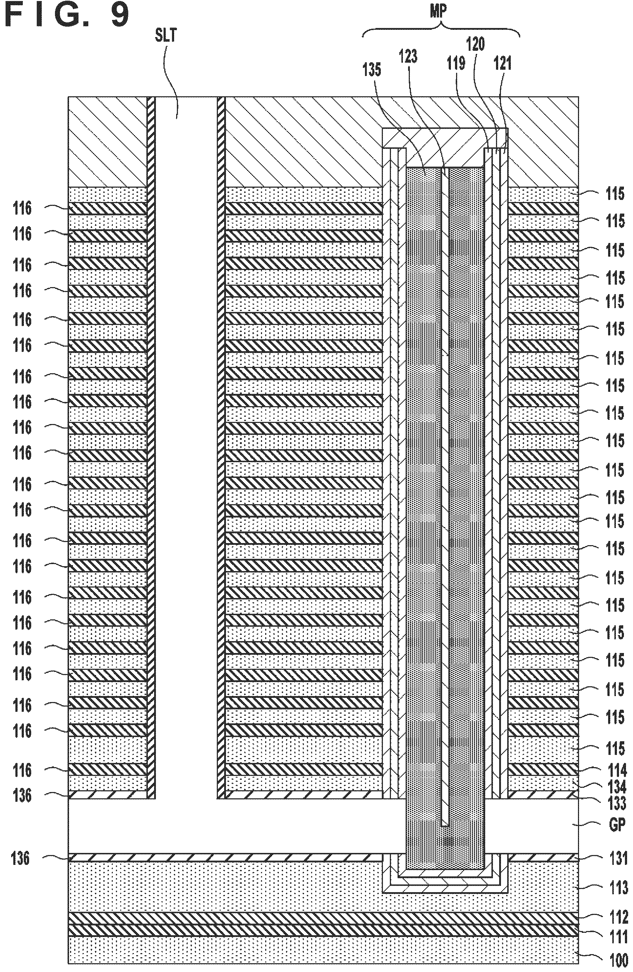

The fourth embodiment of a method of manufacturing a semiconductor device will be described next with reference to Figs. 9 to 17. The fourth embodiment provides a method of manufacturing a semiconductor storage device as an example of the semiconductor device. An example of manufacturing a semiconductor storage device including a NAND string will now be described. The NAND string includes a plurality of thin-film transistors connected in series.

Referring to Figs. 9 to 17, reference numeral 100 denotes a semiconductor substrate; 111, 114, 116, and 136, insulating films; 112 and 113, wiring layers; 115, a gate electrode layer; 119, a tunnel insulating film; 120, a charge accumulation layer; 121, a block insulating film; 135, amorphous silicon; 123, a core layer; 124A, 124B, and 141, silicide layers; 125, a cap layer; and 136, a conductive layer. Reference symbol GP denotes a gap; MP, a memory pillar; and SLT, a slit.

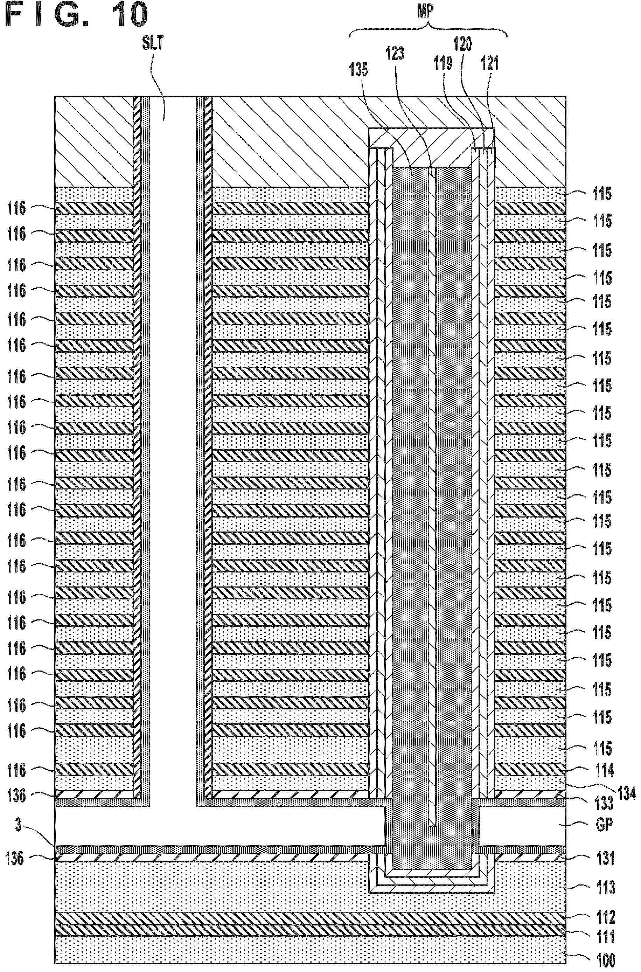

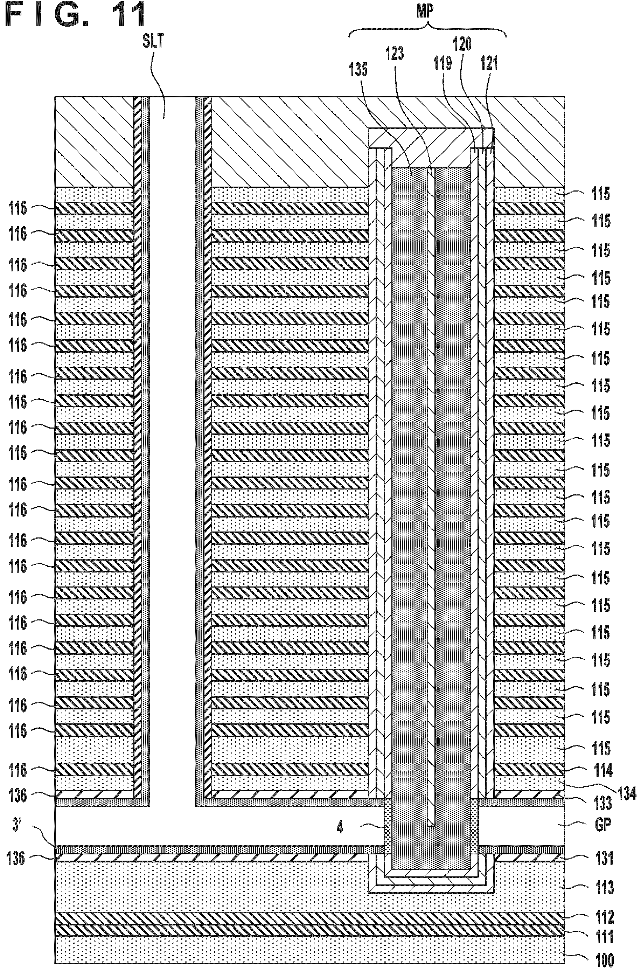

In a state shown in Fig. 9, the gap GP communicates with an external space via the slit SLT. The amorphous silicon 135 corresponds to the above-described amorphous silicon 1, and is to be single-crystallized. The amorphous silicon 135 is exposed to the gap GP. In this state, in a first step shown in Figs. 10 and 11, Ni silicide as a silicide 4 is formed to contact the amorphous silicon 135 by forming, by annealing treatment with heating, a first film 3 containing Ni as a first material to cover the amorphous silicon 135. At this time, in addition to the silicide 4 contacting the amorphous silicon 135, a first material film 3' can be formed to contact the insulating film. The first material film 3' can be removed thereafter.

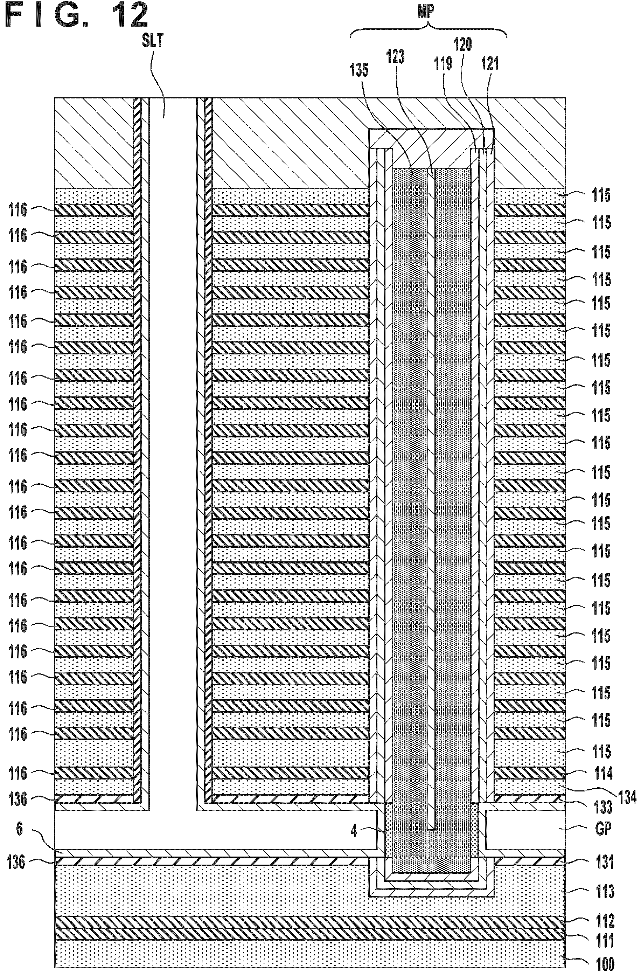

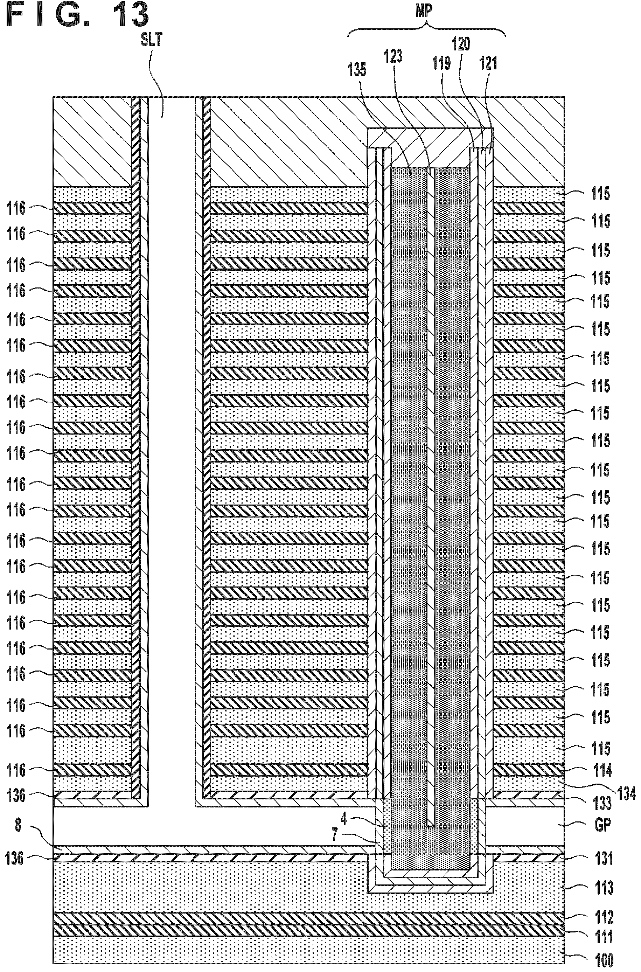

Next, in a second step shown in Figs. 12 and 13, NiAlSi as a compound 7 containing Si, Ni (first material), and Al (second material) is formed to contact the silicide 4 by forming, by treatment with heating, a second film 6 containing Al as the second material to cover the silicide 4. At this time, a second material film 8 as part of the second film 6 remains in a portion covering the insulating film 136 and the like.

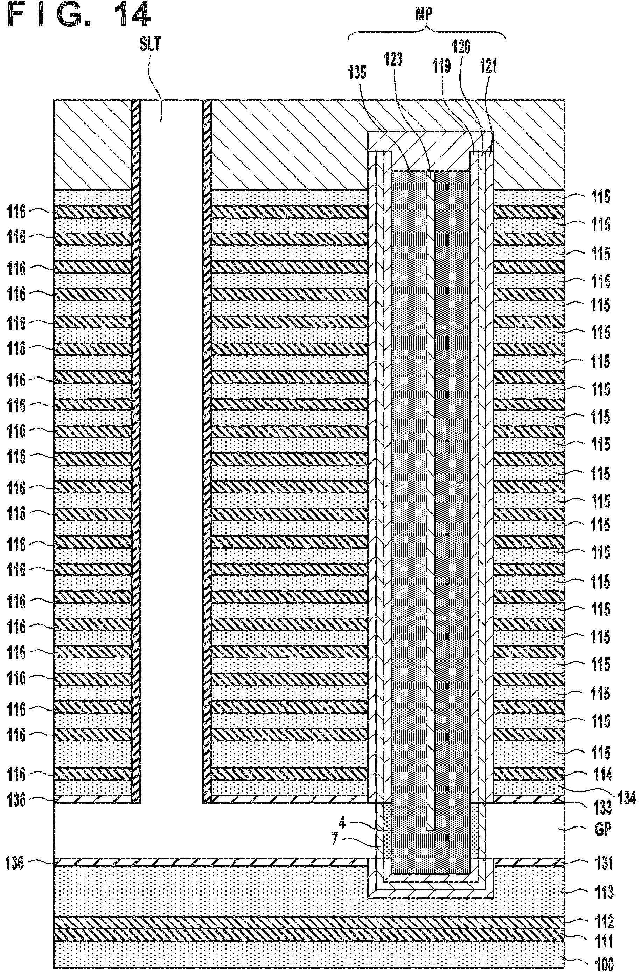

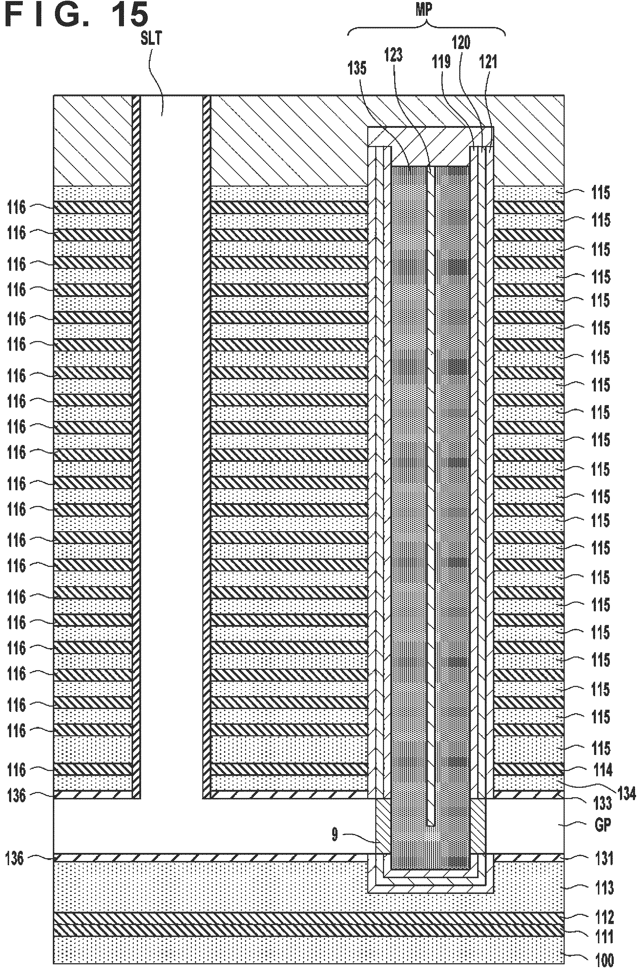

Next, in an arbitrary step shown in Fig. 14, the second material film 8 on the insulating film is removed. Next, in a third step shown in Fig. 15, the silicide 4 remaining after the second step is changed to an NiAlSi film as a compound 9 containing Si, Ni (first material), and Al (second material) by annealing.

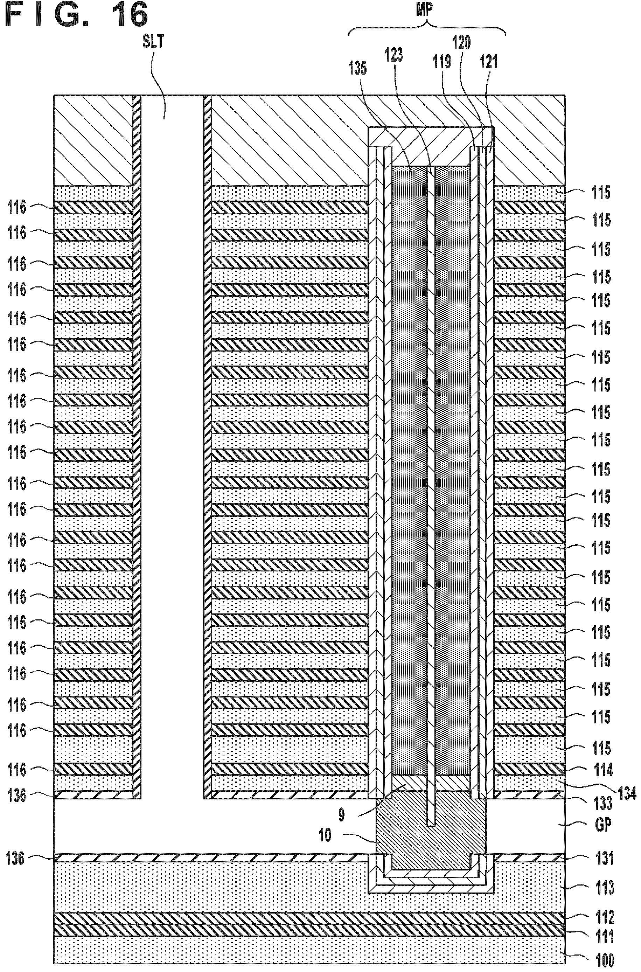

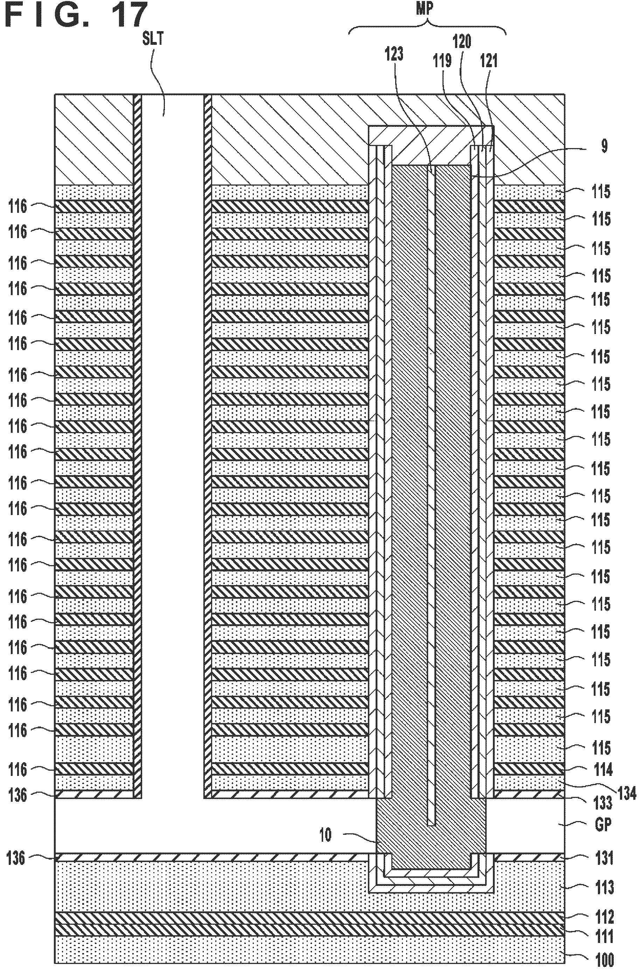

Next, in a fourth step shown in Figs. 16 and 17, at least part of the amorphous silicon 135 remaining after the third step is changed to single-crystal silicon 10 by annealing. The fourth embodiment is advantageous in reducing channel resistance that is a problem for a semiconductor storage device (for example, a 3D NAND memory).

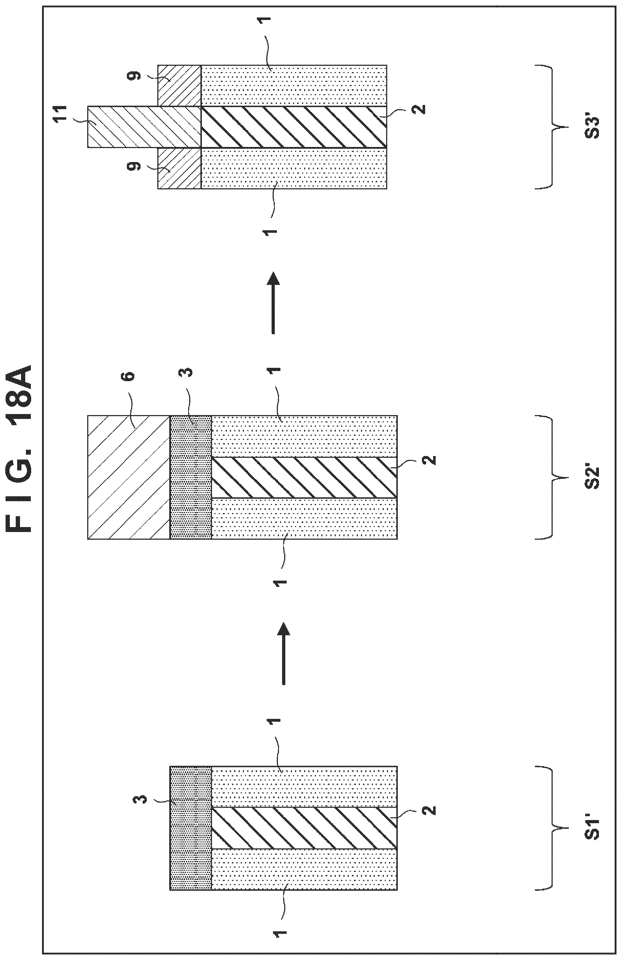

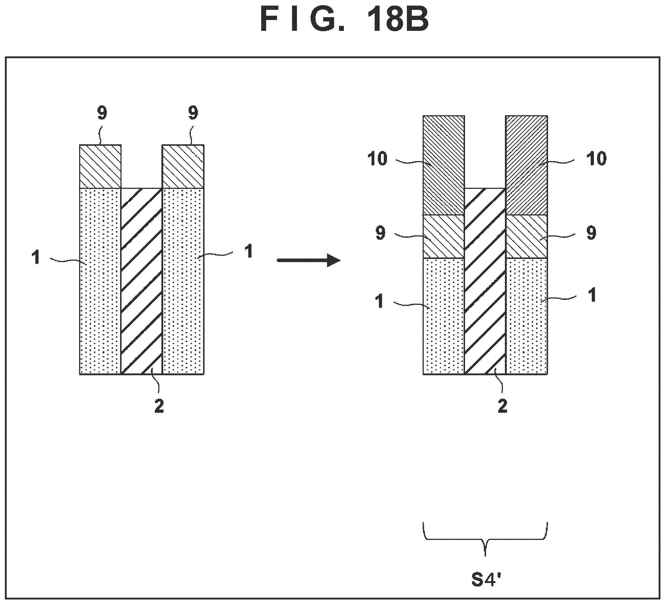

Figs. 18A and 18B are views schematically showing the fifth embodiment of a method of manufacturing a semiconductor device, which includes a conversion step of converting amorphous silicon into single-crystal silicon. Matters not mentioned as the fifth embodiment can comply with the first to third embodiments. The fifth embodiment is applicable to the fourth embodiment.

The fifth embodiment of the method of manufacturing the semiconductor device can include a conversion step of converting amorphous silicon 1 into single-crystal silicon 10. The amorphous silicon 1 can form part of a substrate. The conversion step can include a first step S1' of forming a first film 3 containing Ni as a first material to cover the amorphous silicon 1, a second step S2' of forming a second film 6 containing Al as a second material to cover the first film 3 after the first step S1', and a third step S3' of changing the first and second film into an NiAlSi film as a compound 9 containing Si, Ni (first material), and Al (second material) by annealing after the second step S2'.

This can create a structure in which NiAlSi as the compound 9 is arranged to contact the amorphous silicon 1.

As the first material, instead of Ni, Pd (palladium), Ti (titanium), Cu (copper), Pt (platinum), Co (cobalt), Mo (molybdenum), Mg (magnesium), W (tungsten), Cr (chromium), or Mn (manganese) may be used. That is, the first material can be one material selected from a group consisting of Ni, Pd, Ti, Cu, Pt, Co, Mo, Mg, W, Cr, and Mn.

As the second material, instead of Al, Au (gold), Sb (antimony), In (indium), Ag (silver), or Ga (gallium) may be used. That is, the second material can be one material selected from a group consisting of Al, Au, Sb, In, Ag, and Ga.

A compound containing Si (silicon), Ni (first material), and Al (second material) is preferably, for example, NiAuSi, NiSbSi, NiInSi, NiAgSi, or NiGaSi, instead of NiAlSi.

The conversion step of converting the amorphous silicon 1 into the single-crystal silicon 10 can further include a fourth step S4' of changing at least part of the amorphous silicon 1 remaining after the third step S3' to the single-crystal silicon 10 by annealing. The conversion step may include, between the third step S3' and the fourth step S4', a step of removing a second compound 11 contacting an insulating film 2.

A stacked structure of the amorphous silicon 1, the compound 9, and the single-crystal silicon 10 is formed via the fourth step S4'. The fourth step S4' can include a MILC (Metal Induced Lateral Crystallization) process. The thickness of the second film 6 formed in the second step S2' is preferably larger than the thickness of the first film 3 formed in the first step S1', and smaller than four times the thickness of the first film 3 formed in the first step S1'.

The present invention is not limited to the above embodiments and various changes and modifications can be made within the spirit and scope of the present invention. Therefore, to apprise the public of the scope of the present invention, the following claims are made.

### REFERENCE SIGNS LIST

1: amorphous silicon, 2: insulating film, 3: first film (for example, Ni film), 3'; first material film (for example, Ni film), 4: silicide (for example, Ni silicide), 6: second film (for example, Al film), 7: compound (for example, NiAlSi), 8: second material film (for example, Al film), 9: compound (for example, NiAlSi), 10: single-crystal silicon, 11: second compound (for example, NiAl)

## Claims

1. A method of manufacturing a semiconductor device, including a conversion step of converting amorphous silicon into single-crystal silicon, wherein
the conversion step includes:
a first step of forming a silicide to contact the amorphous silicon by forming, by treatment with heating, a first film containing a first material to cover the amorphous silicon,
a second step of forming a compound formed by Si, the first material, and a second material to contact the silicide by forming, by treatment with heating, a second film containing the second material to cover the silicide after the first step, and
a third step of changing the silicide remaining after the second step to the compound by annealing,
the first material is one material selected from a group consisting of Ni, Pd, Ti, Cu, Pt, Co, Mo, Mg, W, Cr, and Mn, and
the second material is one material selected from a group consisting of Al, Au, Sb, In, Ag, and Ga.

2. The method of manufacturing the semiconductor device, according to claim 1, wherein
the conversion step further includes a fourth step of changing at least part of the amorphous silicon remaining after the third step to a single-crystal silicon by annealing.

3. The method of manufacturing the semiconductor device, according to claim 2, wherein
a stacked structure of the amorphous silicon, the compound, and the single-crystal silicon is formed via the fourth step.

4. The method of manufacturing the semiconductor device, according to claim 3, wherein
the fourth step includes a MILC (Metal Induced Lateral Crystallization) process.

5. The method of manufacturing the semiconductor device, according to any one of claims 1 to 4, wherein
a thickness of the second film formed in the second step is larger than a thickness of the first film formed in the first step, and is smaller than four times the thickness of the first film formed in the first step.

6. The method of manufacturing the semiconductor device, according to any one of claims 1 to 5, wherein
the second material is Al.

7. The method of manufacturing the semiconductor device, according to any one of claims 1 to 5, wherein
the first material is Ni.

8. The method of manufacturing the semiconductor device, according to any one of claims 1 to 5, wherein
the first material is Ni and the second material is Al.

9. The method of manufacturing the semiconductor device, according to any one of claims 1 to 4, wherein
in the first step, a first material film contacting an insulating film is formed in addition to the silicide contacting the amorphous silicon by forming, by treatment with heating, the first film containing the first material to cover the insulating film in addition to the amorphous silicon.

10. The method of manufacturing the semiconductor device, according to claim 9, wherein
the conversion step further includes, between the first step and the second step, a step of removing the first material film contacting the insulating film.

11. The method of manufacturing the semiconductor device, according to claim 10, wherein
in the second step, a second material film contacting the insulating film is formed in addition to the compound contacting the silicide by forming, by treatment with heating, the second film containing the first material to cover the insulating film in addition to the silicide.

12. The method of manufacturing the semiconductor device, according to claim 11, wherein
the conversion step further includes, between the second step and the third step, a step of removing the second material film contacting the insulating film.

13. The method of manufacturing the semiconductor device, according to claim 9, wherein
in the second step, a second compound of the first material and the second material, contacting the insulating film, is obtained in addition to the compound contacting the silicide by forming, by treatment with heating, the second film containing the second material to cover the silicide and the first material film.

14. The method of manufacturing the semiconductor device, according to claim 13, wherein
the conversion step includes, between the second step and the third step, a step of removing the second compound contacting the insulating film.

15. The method of manufacturing the semiconductor device, according to claim 13, wherein
the conversion step further includes, after the third step, a step of removing the second compound contacting the insulating film.

16. A semiconductor device containing single-crystal silicon created by a method of manufacturing a semiconductor device, defined in any one of claims 1 to 15.

17. The semiconductor device according to claim 16, wherein the single-crystal silicon forms part of one of a thin-film transistor and a semiconductor storage device.

18. A method of manufacturing a semiconductor device, including a conversion step of converting amorphous silicon into single-crystal silicon, wherein
the conversion step includes:
a first step of forming a first film containing a first material to cover the amorphous silicon,
a second step of forming a second film containing a second material to cover the first film after the first step, and
a third step of forming a compound containing Si, the first material, and the second material by annealing after the second step,
the first material is one material selected from a group consisting of Ni, Pd, Ti, Cu, Pt, Co, Mo, Mg, W, Cr, and Mn, and
the second material is one material selected from a group consisting of Al, Au, Sb, In, Ag, and Ga.

19. The method of manufacturing the semiconductor device, according to claim 18, wherein
the conversion step further includes a fourth step of changing at least part of the amorphous silicon remaining after the third step to a single-crystal silicon by annealing.

20. The method of manufacturing the semiconductor device, according to claim 19, wherein
a stacked structure of the amorphous silicon, the compound, and the single-crystal silicon is formed via the fourth step.

21. The method of manufacturing the semiconductor device, according to claim 20, wherein
the fourth step includes a MILC (Metal Induced Lateral Crystallization) process.

22. The method of manufacturing the semiconductor device, according to any one of claims 18 to 21, wherein
a thickness of the second film formed in the second step is larger than a thickness of the first film formed in the first step, and is smaller than four times the thickness of the first film formed in the first step.

23. The method of manufacturing the semiconductor device, according to any one of claims 18 to 22, wherein
the second material is Al.

24. The method of manufacturing the semiconductor device, according to any one of claims 18 to 22, wherein
the first material is Ni.

25. The method of manufacturing the semiconductor device, according to any one of claims 18 to 22, wherein
the first material is Ni and the second material is Al.

26. A semiconductor device containing single-crystal silicon created by a method of manufacturing a semiconductor device, defined in any one of claims 18 to 25.

27. The semiconductor device according to claim 26, wherein the single-crystal silicon forms part of one of a thin-film transistor and a semiconductor storage device.

28. A semiconductor device including a stacked structure of amorphous silicon, a compound, and single-crystal silicon, wherein
the compound is a compound of Si, a first material, and a second material,
the first material is one material selected from a group consisting of Ni, Pd, Ti, Cu, Pt, Co, Mo, Mg, W, Cr, and Mn, and
the second material is one material selected from a group consisting of Al, Au, Sb, In, Ag, and Ga.
